(19) Europäisches Patentamt
European Patent Office
Office européen des brevets

(11) Publication number: **0 047 128**
**B1**

(12) **EUROPEAN PATENT SPECIFICATION**

(45) Date of publication of patent specification: **08.08.84**

(51) Int. Cl.³: **G 06 F 15/06,**
H 03 K 19/094,
H 03 K 5/02, H 03 K 19/017

(21) Application number: **81303890.8**

(22) Date of filing: **26.08.81**

# (54) An output buffer circuit.

(30) Priority: **29.08.80 JP 119360/80**

(43) Date of publication of application:
**10.03.82 Bulletin 82/10**

(45) Publication of the grant of the patent:
**08.08.84 Bulletin 84/32**

(84) Designated Contracting States:
**DE FR GB NL**

(56) References cited:
**DE - A - 2 851 825**
**US - A - 4 028 682**
**US - A - 4 153 933**

**RADIO FERNSEHEN ELEKTRONIK, vol. 26, no. 6, 1977, pages 187-188, 197-198 Berlin, DD. M. HOHNE: "Der Mikroprozessor U 808 D"**

(73) Proprietor: **FUJITSU LIMITED**
**1015, Kamikodanaka Nakahara-ku**
**Kawasaki-shi Kanagawa 211 (JP)**

(72) Inventor: **Fujita, Kouichi**
**3016-1-2035, Nagatsuda-cho Midori-ku**
**Yokohama-shi Kanagawa 227 (JP)**

(74) Representative: **Billington, Lawrence Emlyn et al,**
**Haseltine Lake & Co. 9 Park Square**
**Leeds LS1 2LH (GB)**

**EP 0 047 128 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**Description**

The present invention relates to an output buffer circuit and its use in a bidirectional input/output circuit which is, for example, used in an input/output port of a microcomputer or the like.

An integrated circuit, such as a microcomputer, requires a large number of input terminals and a large number of output terminals; however, in order to reduce the number of such terminals, bidirectional input/output circuits are provided. Usually, one bidirectional input/output circuit comprises an output buffer circuit, an input buffer circuit and an input/output terminal to which the output buffer circuit and the input buffer circuit are commonly connected. In this case, an internal output signal generated from the interior of the integrated circuit is transmitted through the output buffer circuit and the input/output terminal to an external load, while an external input signal generated from the exterior of the integrated circuit is transmitted through the input/output terminal and the input buffer circuit to the interior of the integrated circuit.

A first conventional output buffer circuit for use in a bidirectional input/output circuit comprises an inverter circuit. The inverter circuit is formed by a depletion type MOS (broadly, MIS) transistor which serves as a pull-up load and an enhancement type MOS transistor which serves as a driver. In this case, the pull-up resistance of the pull-up transistor is much larger than the on-state resistance of the driver transistor. However, in this output buffer circuit, due to the high resistance of the pull-up transistor and the large external load capacity, there is a disadvantage in that the rising of an external output signal is slow.

A second conventional output buffer circuit for use in a bidirectional input/output circuit comprises an off-buffer circuit instead of the pull-up depletion type transistor of the first conventional output buffer circuit. The off-buffer circuit is formed by an inverter circuit and a pull-up enhancement type MOS transistor. In this case, it is unnecessary to consider ratio of the on-state resistances of the two enhancement type transistors. According to the second conventional output buffer circuit, the slow rising of an external output signal is considerably improved; however, since one of the two enhancement type transistors is always turned on, the output buffer circuit is in a low-impedance state from the side of the input/output terminal, which increases the load of the input buffer circuit. Therefore, the second output buffer circuit is not suitable for a bidirectional input/output circuit.

A third conventional output buffer circuit for use in a bidirectional input/output circuit comprises two enhancement type MOS transistors in addition to the second conventional circuit having an off-buffer circuit, so as to improve the low-impedance of the second conventional circuit. However, this third conventional circuit requires a control circuit for controlling the two additional transistors, so that the control thereof is complex.

U.S. Patent Specification 4,153,933 discloses in Figure 5 thereof an embodiment of an output buffer circuit of the type referred to in the precharacterising part of the attached claim 1. In this embodiment, however, there is no control pulse for the second MIS transistor which has a predetermined duration determined only by the internal circuitry of the charging means. In this embodiment, an additional control signal $\overline{\emptyset}$ must be provided, adding to the size and complexity of the necessary control circuitry. Moreover, no third MIS transistor is provided having a drain connected to the gate of the second MIS transistor, a source connected to the second power supply, and a gate connected to the internal output line.

It is to be noted that the publication Radio Fernsehen Elektronik, vol. 26, no. 6, 1977, pages 187, 188, 197—198 suggests the use of two separate power supplies as envisaged in the present invention, and that West German Offenlegungsschrift 2851825 discloses the use of a capacitor in a bootstrap circuit. It is to be noted however, that in the latter document the capacitor does not have a delaying function, and the relevance of this document to the present invention is minimal.

According to the present invention, there is provided an output buffer circuit for converting an internal output signal into an external output signal, comprising:

first and second power supplies;
an internal output line for receiving said internal output signal;
an external output line for said external output signal;
a pull-up load connected to said first power supply and to said external output line;
a first MIS transistor having a drain connected to said external line, a source connected to said second power supply and a gate connected to said internal output line; charging means connected to said internal output line and to said external output line, for charging said external output line for a time period when the state of said first MIS transistor is changed from the on-state to the off-state, said charging means comprising:
a second MIS transistor having a drain connected to said first power supply, a source connected to said external output line and a gate;
the output buffer circuit being characterised in that the charging means comprises a pulse generator adapted and arranged to generate from a change of state of said internal output signal on said internal output line a pulse to render the second MIS transistor conductive for a predetermined time period thereby to cause said external output line to charge via said second MIS transistor, the pulse generator being such that the duration of said pulse, and hence the duration of said predetermined period, is defined in dependence upon a delay circuit comprised within the pulse generator, without the necessity of any other control signal or circuit being supplied or connected to the pulse generator to define the duration of said pulse, the output buffer circuit being further characterised in that the pulse generator also comprises:

a third MIS transistor having a drain connected to the gate of said second MIS transistor, a source connected to said second power supply, and a gate connected to said internal output line.

An embodiment of the present invention may provide an output buffer circuit for use in a bidirectional input/output circuit, permitting the fast rising of an external output signal and having a high-impedance without necessitating a complex control.

An embodiment of the present invention will now be more clearly understood from the following description, contrasted with conventional circuits, and with reference to the accompanying drawings, wherein:

Fig. 1 is a block diagram illustrating a general bidirectional input/output circuit;

Fig. 2 is a circuit diagram illustrating a first conventional output buffer circuit for use in a bidirectional input/output circuit;

Figs. 3A and 3B are timing diagrams of the signals appearing in the circuit of Fig. 2;

Figs. 4 and 5 are circuit diagrams illustrating second and third conventional output buffer circuit for use in a bidirectional input/output circuit, respectively;

Fig. 6 is a circuit diagram illustrating an embodiment of the output buffer circuit for use in a bidirectional input/output circuit according to the present invention;

Figs. 7A through 7D are timing diagrams of the signals appearing in the circuit of Fig. 6; and

Fig. 8 is a block diagram illustrating a one-chip microcomputer to which the output buffer circuit for use in a bidirectional input/output circuit according to the present invention is applied.

In Fig. 1, which illustrates a general bidirectional input/output circuit, 1 is an integrated circuit chip; 2 is an internal output line; 3 is an output buffer circuit; 4 is an external input/output line; 5 is an external input/output terminal; 6 is an input buffer circuit; 7 is an internal input line; and 8 is an external circuit. A bidirectional input/output circuit is comprised of the elements 2 through 7. In this case, an internal signal generated from the interior of the integrated circuit chip 1 is transmitted from the internal output line 2 through the output buffer circuit 3, the external input/output line 4 and the external input/output terminal 5 to the external circuit 8. Contrary to this, an external signal generated from the external circuit 8 is transmitted through the external input/output terminal 5, the external input/output line 4, the input buffer circuit 6 and the internal input line 7 to the interior of the integrated circuit chip 1.

Fig. 2 is a circuit diagram illustrating a first conventional output buffer circuit for use in a bidirectional input/output circuit. In Fig. 2, the output buffer circuit 3 comprises an inverter circuit, in which a depletion type MOS transistor $Q_{31}$ connected to a power supply $V_{CC}$, which serves as a pull-up load, and an enhancement type MOS transistor $Q_{32}$ connected to another power supply $V_{SS}$, which serves as a driver, are connected in series. Similarly, the input buffer circuit 6 comprises an inverter circuit, in which a depletion type MOS transistor $Q_{61}$ and an enhancement type MOS transistor $Q_{62}$ are connected in series.

Figs. 3A and 3B are timing diagrams of the signals appearing in the circuit of Fig. 2. Referring to Figs. 3A and 3B, the operation of the circuit of Fig. 2, that is, the output buffer circuit 3 will now be explained. At a time $t_1$, when the potential $V_1$ at the internal output line 2 is changed from high to low, as illustrated in Fig. 3A, the transistor $Q_{32}$ cuts off so that the potential at the external input/output line 4 is changed from low to high. As a result, an external load capacity $C_L$ of the external circuit 8 is charged. However, in this case, since the pull-up resistance of the transistor $Q_{31}$ which is, for example, on the order of kΩ is much larger than the on-state resistance of the transistor $Q_{32}$ and, in addition, the capacity $C_L$ is usually large, that is, 50 to 100 pF, therefore, the rising of the potential $V_2$ is slow, as illustrated in Fig. 3B. For example, the rising time $T_1$ is on the order of 100 nsec. Next, at a time $t_2$, when the potential $V_1$ at the internal output line 2 is changed from low to high, as illustrated in Fig. 3A, the transistor $Q_{32}$ is turned on so that the potential $V_2$ rapidly falls, as illustrated in Fig. 3B.

Thus, in the output buffer circuit 3 of Fig. 2, there is a problem in that the rising of the potential $V_2$ of an external output signal is slow. In order to solve such a problem, one approach is to reduce both of the on-state resistances of the transistors $Q_{31}$ and $Q_{32}$; however, in this case, the areas for the transistors $Q_{31}$ and $Q_{32}$ are increased, which is not practical as a design for integrated circuits.

On the other hand, when the input buffer circuit 6 is made use of, the potential $V_1$ at the internal output line 2 is usually low, so that the output buffer circuit 3 is in a high-impedance state from the side of the external input/output terminal 5. In addition, the effective capacity $C_I$ of the internal circuit of the integrated circuit chip 1 is very small, that is, generally 0.01 to 0.1 pF, so that the rising of the potential at the internal input line 7 is not so slow as that of the potential $V_2$ in the case of the output operation.

Note that this rising time is usually about 10 nsec.

Fig. 4 is a circuit diagram illustrating a second conventional output buffer circuit for use in a bidirectional input/output circuit. In Fig. 4, an enhancement type MOS transistor $Q_{31}'$ and an inverter circuit $I_1$, which serve as an off-buffer circuit, are provided instead of the depletion type MOS transistor $Q_{31}$ of Fig. 2. In Fig. 4, when the potential $V_1$ at the internal output line 2 is changed from high to low, the transistor $Q_{32}$ cuts off and in addition, the transistor $Q_{31}'$ is turned on due to the high potential level of the output of the inverter circuit $I_1$. As a result, the potential $V_2$ at the external input/output line 4 rapidly rises. Contrary to this, when the potential $V_1$ at the internal output line 2 is changed from low to high, the transistor $Q_{32}$ is turned on and the transistor $Q_{31}'$ cuts off due to the low potential level of the output of the inverter circuit $I_1$. As a result, the potential $V_2$ at the external input/output line 4 rapidly falls. In this case, as is different from Fig. 2, since it is unnecessary to consider the ratio of the on-state resistance of the transistor $Q_{31}'$ to that of the transistor $Q_{32}$, the on-state resistance of the transistor $Q_{31}'$ can be reduced regardless of the transistor $Q_{32}$. Therefore, in consideration of only the output buffer circuit 3, it is possible for the slow rising of the potential of the output thereof to be considerably improved.

However, in consideration of the input buffer circuit 6, one of the transistors $Q_{31}'$ and $Q_{32}$ is always turned on, so that the output buffer circuit 3 is always in a low-impedance state from the external input/output terminal 5. As a result, the load of the input buffer circuit 6 becomes large. Therefore, the on-state resistance of the transistor $Q_{31}'$ cannot be reduced. This means that the output buffer circuit 3 of Fig. 4 is not suitable for a bidirectional input/output circuit.

Fig. 5 is a circuit diagram illustrating a third conventional output buffer circuit. In Fig. 5, two enhancement type transistors $Q_{33}$ and $Q_{34}$ are added to the output buffer circuit 3 of Fig. 4 having an off-buffer circuit. In order to improve the low-impedance of the output buffer circuit 3, when the input buffer circuit 6 is made use of, the potential at a control line 9 is forced to be high so as to turn on the transistors $Q_{33}$ and $Q_{34}$. As a result, both of the transistors $Q_{31}'$ and $Q_{32}$ are turned off so that the output buffer circuit 3 becomes in a high-impedance state from the side of the external input/output terminal 5. However, the circuit of Fig. 5 requires a circuit for controlling the potential at the control line 9, so that this circuit is not practical due to the complexity of an input and output control.

Fig. 6 is a circuit diagram illustrating an embodiment of the output buffer circuit for use in a bidirectional input/output circuit according to the present invention. In Fig. 6, a charging circuit formed by a charging transistor $Q_{35}$ which has a sufficiently small on-state resistance and a pulse generating circuit CT is added to the output buffer circuit 3 of Fig. 2. The pulse generating circuit CT generates a pulse having a predetermined time-period when the potential $V_1$ at the internal output line 2 falls.

The pulse generating circuit CT will be explained in more detail. The pulse generating circuit CT comprises two inverter circuits $I_2$ and $I_3$ connected in series, a capacitor $C_{31}$ between the inverter circuits $I_2$ and $I_3$, and an enhancement type MOS transistor $Q_{36}$ connected to the output of the inverter circuit $I_3$. In this case, the inverter circuit $I_2$ comprises a depletion type MOS transistor $Q_{37}$ and an enhancement type MOS transistor $Q_{38}$ connected in series, while the inverter circuit $I_3$ comprises a depletion type MOS transistor $Q_{39}$ and an enhancement type MOS transistor $Q_{40}$ connected in series.

Figs. 7A through 7D are timing diagrams of the signals appearing in the circuit of Fig. 6. The operation of the circuit of Fig. 6 will be explained with reference to Figs. 7A through 7D. Before a time $t_1$, when the potential at the internal output line 2 is high, as illustrated in Fig. 7A, the transistor $Q_{32}$ and $Q_{38}$ are turned on and, accordingly, the transistor $Q_{40}$ is turned on. As a result, the potential $V_4$ is low, as illustrated in Fig. 7C, so that the charging transistor $Q_{35}$ does not operate. Next, at the time $t_1$, when the potential $V_1$ at the internal output line 2 is changed from high to low, as illustrated in Fig. 7A, all the transistors $Q_{32}$, $Q_{36}$, $Q_{38}$ and $Q_{40}$ are turned off. At this time, after the transistor $Q_{38}$ is turned off, the potential $V_3$ at the output of the inverter circuit $I_2$ is expected to be pulled up to a high level by charging the capacitor $C_{31}$ through the transistor $Q_{37}$; however, in this case, as illustrated in Fig. 7B, the potential $V_3$ has a delay time $T_2$ due to the resistance of the transistor $Q_{37}$ and the capacity of the capacitor $C_{31}$. As a result, the transistor $Q_{40}$ remains in an off-state for the time-period $T_2$ and accordingly, the potential $V_4$ at the output of the circuit CT also remains at a high level, as illustrated in Fig. 7C, so as to turn on the charging transistor $Q_{35}$. As a result, the potential $V_2$ at the input/output line 4 rapidly rises as illustrated in Fig. 7D. In this case, the rising time $T_1'$ is on the order of 10 nsec. After the time-period $T_2$ passes, the transistor $Q_{40}$ is turned on so that the potential $V_4$ rapidly falls, as illustrated in Fig. 7C, so as to cut off the transistor $Q_{35}$. As a result, the potential $V_2$ gradually rises up to the level $V_{CC}$ by the pull-up transistor $Q_{31}$, as illustrated in Fig. 7D.

Next, at a time $t_2$, when the potential $V_1$ is changed from low to high, the transistor $Q_{36}$ is turned on, so that the transistor $Q_{35}$ does not conduct. That is, in this case, the same falling characteristics as Fig. 2 are obtained.

Thus, the pulse generating circuit CT detects a falling of the potential $V_1$ at the internal output line 2, that is, a change of the transistor $Q_{32}$ from the on-state to the off-state, and as a result, generates a pulse, having a predetermined time-period $T_2$ (about 10 to 100 nsec), to the charging transistor $Q_{35}$. As a result, the external input/output line 4 is charged by the low-resistance transistor $Q_{35}$ and the high-resistance transistor $Q_{31}$ for the time-period $T_2$ and after that, the input/output line 4 is pulled up to the level $V_{CC}$ by the high-resistance transistor $Q_{31}$.

On the other hand, when the input buffer circuit 6 is made use of, the potential $V_1$ at the internal output line 2 is caused to be low so as to turn off the transistor $Q_{32}$; however, at this case, the transistors $Q_{40}$ and $Q_{35}$ are turned on and off, respectively, and accordingly, the output buffer circuit 3 is in a high-impedance state from the side of the external input/output terminal 5. Therefore, when an external input signal generated from the external circuit 8 is transmitted from the external input/output terminal 5 to the input buffer circuit 6, the load thereof is small. In addition, a control method for such an input operation is effected by only causing the potential $V_1$ at the internal output line to be low.

In Fig. 6, all the transistors are of an n-channel type; however, it should be noted that these transistors can be of a p-channel type. In this case, at the time $t_1$, the potential at the internal output line 2 is changed from low to high.

Fig. 8 is a block diagram illustrating a one-chip microcomputer to which the output buffer circuit for use in a bidirectional input/output circuit according to the present invention is applied. In Fig. 8, 81 is a read-only memory (ROM); 82 is a random-access memory (RAM); 83 is an arithmetic and logic unit (ALU) and the like; and 84 is a control logic unit for receiving control signals $C_1$ through $C_6$ and controlling the ALU 83. These elements 81 through 84 are surrounded by three data buses 85, 86 and 87 which are connected to an input port 88, output ports 89, 90 and 91, and input/output ports 92, 93, 94 and 95. Four output buffer circuits according to the present invention are used in each of the input/output ports 92, 93, 94 and 95.

As explained hereinbefore, the output buffer circuit for use in a bidirectional input/output circuit according to the present invention has an advantage, as compared with the conventional circuits, in that the rising characteristics of an external output signal is improved and a high-impedance is obtained without complex control when the input buffer circuit is made use of.

## Claims

1. An output buffer circuit for converting an internal output signal into an external output signal, comprising:

first and second power supplies ($V_{CC}$, $V_{SS}$);

an internal output line (2) for receiving said internal output signal;

an external output line (4) for said external output signal;

a pull-up load ($Q_{31}$) connected to said first power supply ($V_{CC}$) and to said external output line (4);

a first MIS transistor ($Q_{32}$) having a drain connected to said external output line (4), a source connected to said second power supply ($V_{SS}$) and a gate connected to said internal output line (2); charging means (CT, $Q_{35}$) connected to said internal output line (2) and to said external output line (4), for charging said external output line (4) for a time period when the state of said first MIS transistor ($Q_{32}$) is changed from the on-state to the off-state, said charging means comprising:

a second MIS transistor ($Q_{35}$) having a drain connected to said first power supply ($V_{CC}$), a source connected to said external output line (4) and a gate;

the output buffer circuit being characterised in that the charging means comprises a pulse generator (CT) adapted and arranged to generate from a change of state of said internal output signal on said internal output line (2) a pulse to render the second MIS transistor ($Q_{35}$) conductive for a predetermined time period thereby to cause said external output line (4) to charge via said second MIS transistor ($Q_{35}$), the pulse generator (CT) being such that the duration of said pulse, and hence the duration of said predetermined period, is defined in dependence upon a delay circuit ($I_2C_{31}$) comprised within the pulse generator (CT), without the necessity of any other control signal or circuit being supplied or connected to the pulse generator (CT) to define the duration of said pulse, the output buffer circuit being further characterised in that the pulse generator (CT) also comprises:

a third MIS transistor ($Q_{36}$) having a drain connected to the gate of said second MIS transistor ($Q_{35}$), a source connected to said second power supply ($V_{SS}$), and a gate connected to said internal output line (2).

2. An output buffer circuit as set forth in claim 1, wherein said pull-up load comprises a depletion type source-gate connected MIS transistor ($Q_{31}$).

3. An output buffer circuit as set forth in claim 1 or 2, wherein said pulse generator comprises:

a first inverter circuit ($I_2$) having an input connected to said internal output line (2) and having an output;

a capacitor ($C_{31}$) having an electrode connected to the output of said first inverter circuit ($I_2$) and having another electrode connected to said second power supply ($V_{SS}$), the first

inverter circuit ($I_2$) and the capacitor ($C_{31}$) being comprised in said delay circuit; and
a second inverter circuit ($I_3$) having an input connected to the output of said first inverter circuit ($I_2$) and having an output connected to the gate of said second MIS transistor ($Q_{35}$).

4. An output buffer circuit as set forth in claim 3, wherein each of said first and second inverter circuits ($I_2$, $I_3$) comprises a depletion type MIS transistor ($Q_{37}$, $Q_{39}$) and an enhancement type MIS transistor ($Q_{38}$, $Q_{40}$) connected in series.

5. An output buffer circuit as set forth in any preceding claim, wherein said first, second and third MIS transistors ($Q_{32}$, $Q_{35}$, $Q_{36}$) are of an enhancement type.

6. An output buffer circuit as set forth in any preceding claim, further comprising an input buffer circuit (6) connected to said external output line (4), so that said external output line (4) serves also as an external input line.

7. An output circuit as set forth in claim 6, wherein said input buffer circuit (6) comprises a third inverter circuit having an input connected to said external input/output line and having an output connected to an internal input line.

8. An output circuit as set forth in claim 7, wherein said third inverter circuit comprises a depletion type MIS transistor ($Q_{61}$) and an enhancement type MIS transistor ($Q_{62}$) connected in series.

9. An output circuit as set forth in any preceding claim, wherein said output circuit is incorporated into each of the input/output ports of a one-chip microcomputer.

**Patentansprüche**

1. Ausgangspufferschaltung zum Konvertieren eines internen Ausgangssignals in ein externes Ausgangssignal, mit:

ersten und zweiten Energiversorgungen ($V_{CC}$, $V_{SS}$),
einer internen Ausgangsleitung (2) zum Empfang des genannten internen Ausgangssignals,
einer externen Ausgangsleitung (4) für das genannte externe Ausgangssignal,
einer Hochzieh-Last ($Q_{31}$), die mit der genannten ersten Energieversorgung ($V_{CC}$) und mit der genannten externen Ausgangsleitung (4) verbunden ist,
einem ersten MIS-Transistor ($Q_{32}$), dessen Drainelektrode mit der genannten externen Ausgangsleitung (4), dessen Source-Elektrode mit der genannten zweiten Energieversorgung ($V_{SS}$) und dessen Gate-Elektrode mit der genannten internen Ausgangsleitung (2) verbunden ist,
Ladungseinrichtungen (CT, $Q_{35}$), die mit der genannten internen Ausgangsleitung (2) und mit der genannten externen Ausgangsleitung (4) verbunden sind, um die genannte externe Ausgangsleitung (4) während einer Zeitperiode zu laden, wenn der Status des genannten ersten MIS-Transistors ($Q_{32}$) vom EIN-Zustand in den AUS-Zustand wechselt, wobei die Ladeeinrichtung,
einen zweiten MIS-Transistor ($Q_{35}$) umfaßt, der eine Drain-Elektrode, die mit der genannten ersten Energieversorgung ($V_{CC}$) verbunden ist, eine Source-Elektrode, die mit der genannten externen Ausgangsleitung (4) verbunden ist, und eine Gate-Elektrode umfaßt,
wobei die Ausgangspufferschaltung dadurch gekennzeichnet ist, daß die Ladeeinrichtung einen Impulsgenerator (CT) umfaßt, der so ausgelegt und angeordnet ist, daß er von dem Wechsel des Zustands des genannten internen Ausgangssignals auf der genannten internen Ausgangsleitung (2) einen Impuls generiert, um den zweiten MIS-Transistor ($Q_{35}$) für eine vorbestimmte Zeitperiode leitend zu machen, um dadurch zu verursachen, daß die genannte externe Ausgangsleitung (4) über den genannten zweiten MIS-Transistor ($Q_{35}$) lädt, wobei der Impulsgenerator (CT) so ist, daß die Dauer des genannten Impulses und folglich die Dauer der genannten vorbestimmten Periode in Abhängigkeit von einer Verzögerungsschaltung ($I_2C_{31}$) definiert wird, welche in dem Impulsgenerator (CT) enthalten ist, ohne die Notwendigkeit irgend eines anderen Steuersignals oder einer Schaltung, welches dem Impulsgenerator zugeführt oder mit diesem verbunden ist, um die Dauer des genannten Impulses zu definieren,
wobei die Ausgangspufferschaltung ferner dadurch gekennzeichnet ist, daß der Impulsgenerator (CT) ferner umfaßt:
einen dritten MIS-Transistor ($Q_{36}$), mit einer Drain-Elektrode, die mit der Gate-Elektrode des genannten zweiten MIS-Transistors ($Q_{35}$) verbunden ist, eine Source-Elektrode, die mit der genannten zweiten Energieversorgung ($V_{SS}$) verbunden ist und eine Gateelektrode, die mit der genannten internen Ausgangsleitung (2) verbunden ist.

2. Ausgangspufferschaltung nach Anspruch 1, bei welcher die Hochzieh-Last einen Source-Gate-verbundenen MIS-Transistor ($Q_{31}$) vom Verarmungstyp umfaßt.

3. Ausgangspufferschaltung nach Anspruch 1 oder 2, bei welcher der genannte Impulsgenerator umfaßt:

eine erste Inverterschaltung ($I_2$) mit einem Eingang, der mit der genannten internen Ausgangsleitung (2) verbunden ist und mit einem Ausgang,
einem Kondensator ($C_{31}$) der eine Elektrode hat, die mit dem Ausgang der genannten ersten Inverterschaltung ($I_2$) verbunden ist, und eine andere Elektrode, die mit der genannten zweiten Energieversorgung ($V_{SS}$) verbunden ist, wobei die ersten Inverterschaltung ($I_2$)

und der Kondensator ($C_{31}$) in der genannten Verzögerungsschaltung enthalten sind, und eine zweite Inverterschaltung ($I_3$), die einen Eingang hat, der mit dem Ausgang der genannten ersten Inverterschaltung ($I_2$) verbunden ist, und die einen Ausgang hat, der mit der Gate-Elektrode des genannten zweiten MIS-Transistors ($Q_{35}$) verbunden ist.

4. Ausgangspufferschaltung nach Anspruch 3, bei welcher die erste und die zweite Inverterschaltung ($I_2$, $I_3$) einen MIS-Transistor ($Q_{37}$, $Q_{39}$) vom Verarmungstyp und einen MIS-Transistor ($Q_{38}$, $Q_{40}$) vom Anreicherungstyp umfaßt, die in Reihe geschaltet sind.

5. Ausgangspufferschaltung nach einem der vorhergehenden Ansprüche, bei welcher die drei genannten MIS-Transistoren ($Q_{32}$, $Q_{35}$, $Q_{36}$) vom Anreicherungstyp sind.

6. Ausgangspufferschaltung nach einem der vorhergehenden Ansprüche, ferner gekennzeichnet durch eine Eingangspufferschaltung (6), welche mit der genannten externen Ausgangsleitung (4) so verbunden ist, daß die genannte externe Ausgangsleitung (4) als eine externe Eingangsleitung dient.

7. Ausgangsschaltung nach Anspruch 6, bei welcher die genannte Eingangspufferschaltung (6) eine dritte Inverterschaltung umfaßt, die einen Eingang hat, der mit der genannten äußeren Eingangs/Ausgangs-Leitung verbunden ist, und die einen Ausgang hat, der mit einer internen Eingangsleitung verbunden ist.

8. Ausgangsschaltung nach Anspruch 7, bei welcher die genannte dritte Inverterschaltung einen MIS-Transistor ($Q_{61}$) von Verarmungstyp und einen MIS-Transistor ($Q_{62}$) vom Anreicherungstyp in Reihe geschaltet umfaßt.

9. Ausgangsschaltung nach einem der vorhergehenden Ansprüche, bei welcher die Ausgangsschaltung in jeden der Eingangs-Ausgangs-Ports eines 1-Chip-Mikrocomputers angeordnet ist.

**Revendications**

1. Circuit tampon de sortie destiné à convertir un signal de sortie intérieur en un signal de sortie extérieur, comprenant une première et une seconde source d'alimentation ($V_{CC}$, $V_{SS}$); une ligne de sortie intérieure (2) destinée à recevoir ledit signal de sortie intérieur; une ligne de sortie extérieure (4) pour ledit signal de sortie extérieur; une charge d'élévation ($Q_{31}$) connectée à ladite première source d'alimentation ($V_{CC}$) et à ladite ligne de sortie extérieure (4); un premier transistor MIS ($Q_{32}$) avec un drain connecté à ladite ligne de sortie extérieure (4); une source connectée à ladite seconde source d'alimentation ($V_{SS}$) et une grille connectée à ladite ligne de sortie intérieure (2); un dispositif de charge (CT, $Q_{35}$) connecté à ladite ligne de sortie intérieure (2) et à ladite ligne de sortie extérieure (4), pour charger ladite ligne de sortie extérieur (4) pendant une période dans laquelle l'état dudit premier transistor MIS ($Q_{32}$) passe de l'état débloqué à l'état bloqué, ledit dispositif de charge comprenant un second transistor MIS ($Q_{35}$) avec un drain connecté à ladite première source d'alimentation ($V_{CC}$), une source connectée à ladite ligne de sortie extérieure (4) et une grille; le circuit tampon de sortie étant caractérisé en ce que le dispositif de charge comporte un générateur d'impulsions (CT) agencé et disposé pour produire, à partir d'un changement d'état dudit signal de sortie intérieur sur ladite ligne de sortie intérieure (2) une impulsion pour rendre conducteur le second transistor MIS ($Q_{35}$) pendant une période prédéterminée afin que ladite ligne de sortie extérieure (4) soit chargée par ledit second transistor MIS ($Q_{35}$), le générateur d'impulsions (CT) étant tel que la durée de ladite impulsion, et par conséquent la durée de ladite période prédéterminée, soit définie en fonction d'un circuit à retard ($I_2C_{31}$) compris dans le générateur d'impulsions (CT), sans qu'il soit nécessaire qu'un autre signal ou un autre circuit de commande soit fournir ou connecté au générateur d'impulsions (CT) pour définir la durée de ladite impulsion, le circuit tampon de sortie étant en outre caractérisé en ce que le générateur d'impulsions (CT) comporte également un troisième transistor MIS ($Q_{36}$) avec un drain connecté à la grille dudit second transistor MIS ($Q_{35}$), une source connectée à ladite seconde source d'alimentation ($V_{SS}$) et une grille connectée à ladite ligne de sortie intérieure (2).

2. Circuit tampon de sortie selon la revendication 1, dans lequel ladite charge d'élévation consiste en un transistor MIS ($Q_{31}$) de type appauvri avec une connection source-grille.

3. Circuit tampon de sortie selon la revendication 1 ou 2, dans lequel ledit générateur d'impulsions comporte un premier circuit inverseur ($I_2$) avec une entrée connectée à ladite ligne de sortie intérieure (2) et une sortie, un condensateur ($C_{31}$) dont une électrode connectée à la sortie dudit premier circuit inverseur ($I_2$) et dont une autre électrode est connectée à ladite seconde source d'alimentation ($V_{SS}$), le premier circuit inverseur ($I_2$) et le condensateur ($C_{31}$) faisant partie dudit circuit à retard et un second circuit inverseur ($I_3$) avec une entrée connectée à la sortie dudit premier inverseur ($I_2$) et avec une sortie connectée à la grille dudit second transistor MIS ($Q_{35}$).

4. Circuit tampon de sortie selon la revendication 3, dans lequel chacun dudit premier et dudit second circuits inverseurs ($I_2$, $I_3$) consiste en un transistor MIS de type appauvri ($Q_{37}$, $Q_{39}$) et en un transistor MIS de type enrichi ($Q_{38}$, $Q_{40}$) connectés en série.

5. Circuit tampon de sortie selon l'une quelconque des revendications précédentes, dans lequel, le premier, le second et le troisième transistors MIS ($Q_{34}$, $Q_{35}$, $Q_{36}$) sont d'un type enrichi.

6. Circuit tampon de sortie selon l'une quelconque des revendications précédentes, comprenant en outre un circuit tampon d'entrée (6) connecté à ladite ligne de sortie extérieure (4) de manière que ladite ligne de sortie extérieure (4) serve également de ligne d'entrée extérieure.

7. Circuit de sortie selon la revendication 6, dans lequel ledit circuit tampon d'entrée (6) consiste en un troisième circuit inverseur avec une entrée connectée à ladite ligne d'entrée/sortie extérieure et une sortie connectée à une ligne d'entrée intérieure.

8. Circuit de sortie selon la revendication 7, dans lequel ledit trosième circuit inverseur consiste en un transistor MIS de type appauvri ($Q_{61}$) et en un transistor MIS de type enrichi ($Q_{62}$) connectés en série.

9. Circuit de sortie selon l'une quelconque des revendications précédentes, dans lequel ledit circuit de sortie est incorporé dans chacun des connections d'entrée/sortie d'un microcalculateur en une seule pastille.

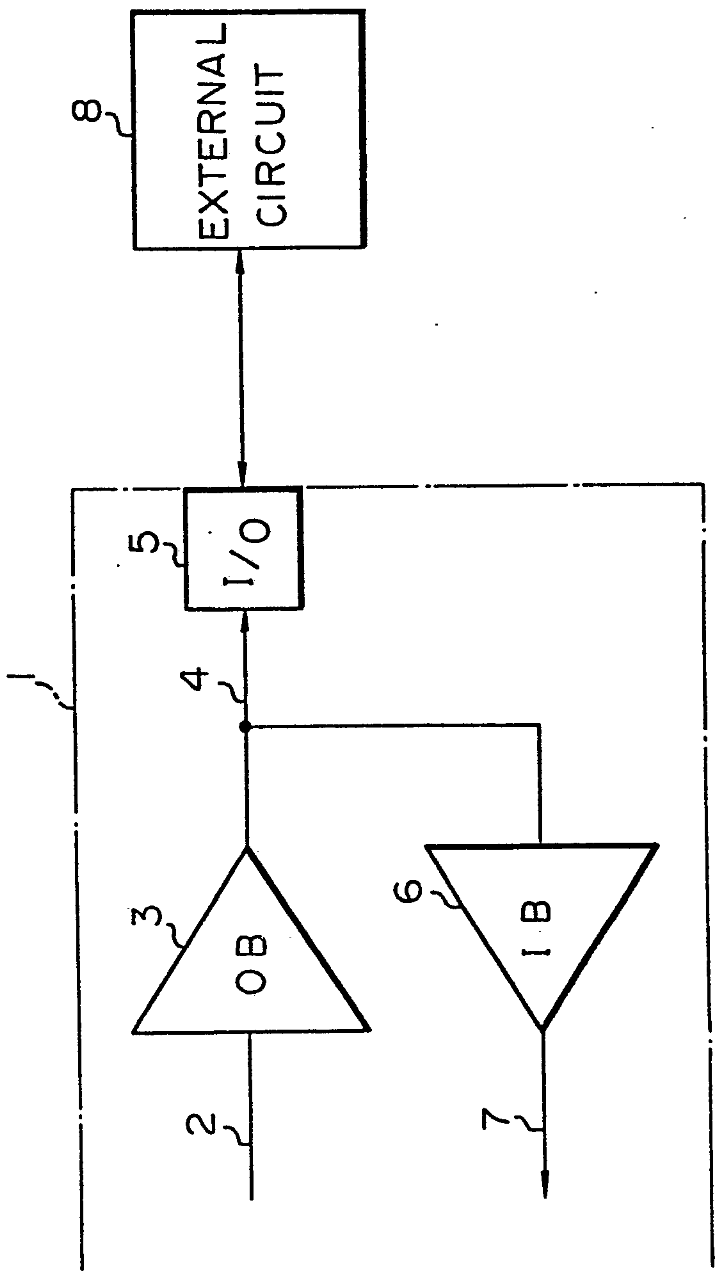


Fig. 1

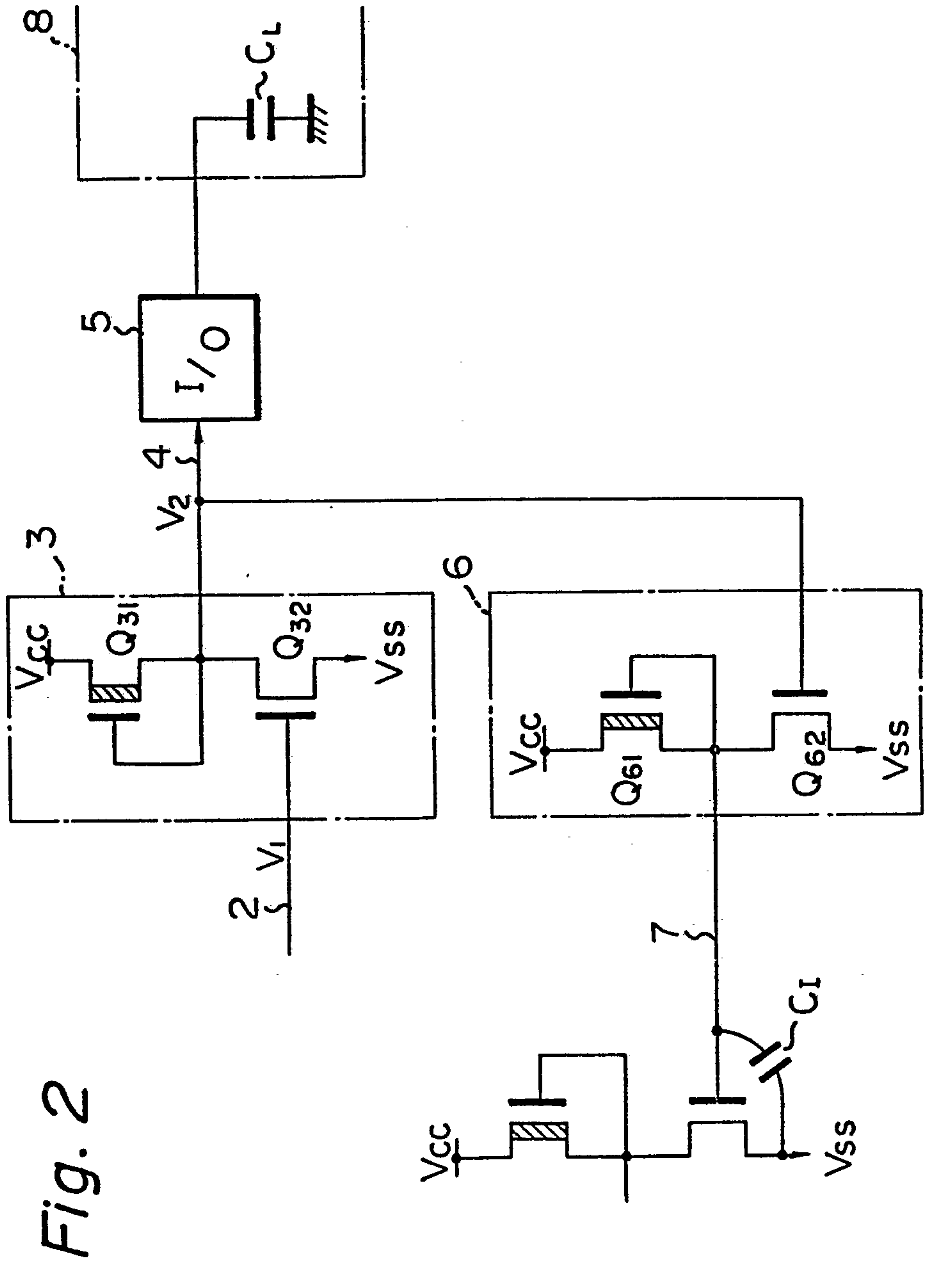


Fig. 2

Fig. 3A

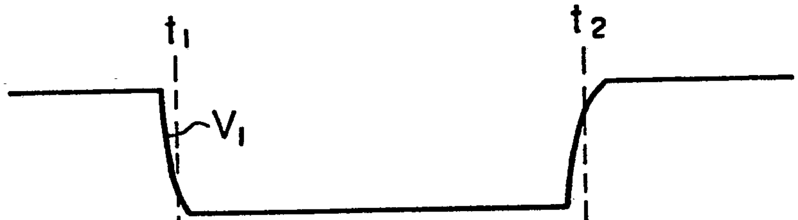


Fig. 3B

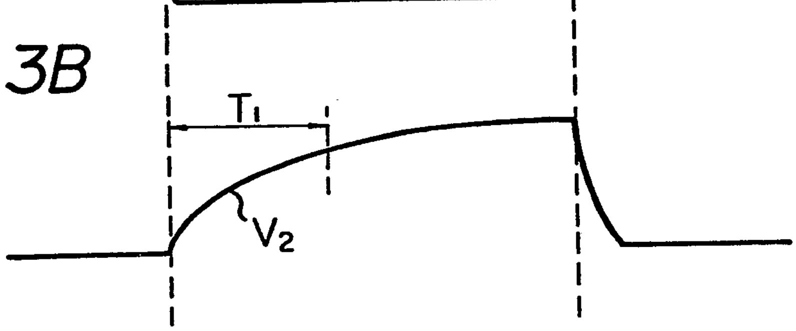

*Fig. 4*

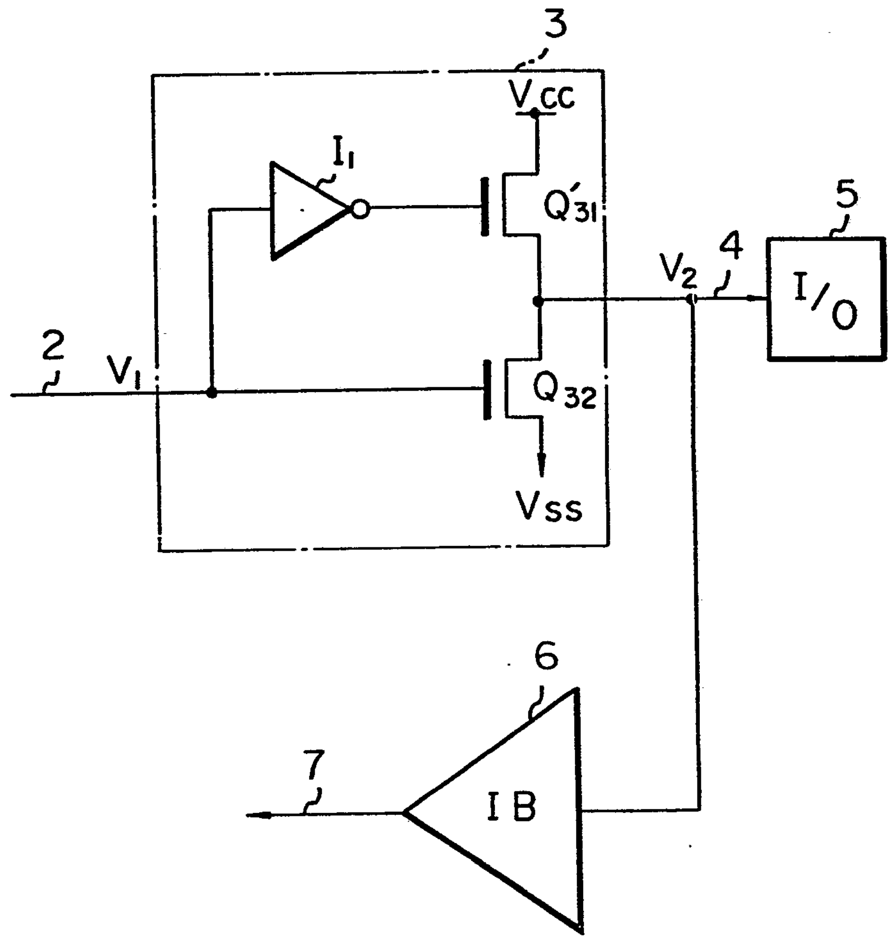

Fig. 5

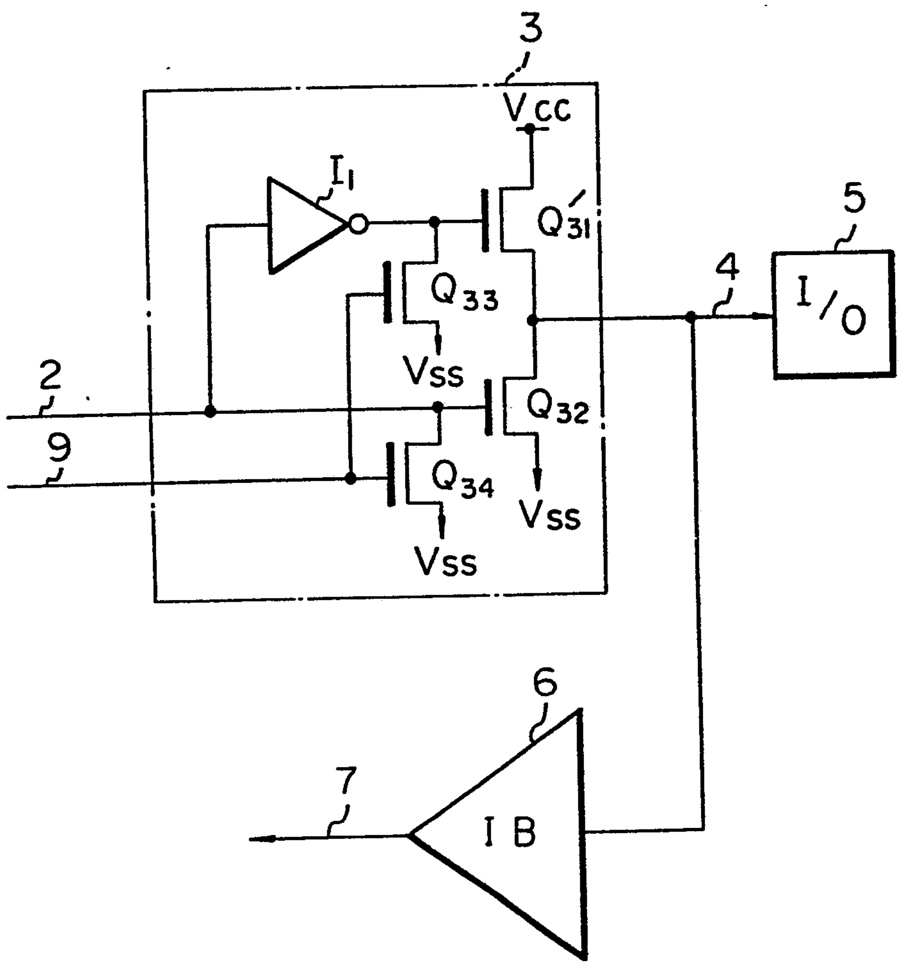

Fig. 6

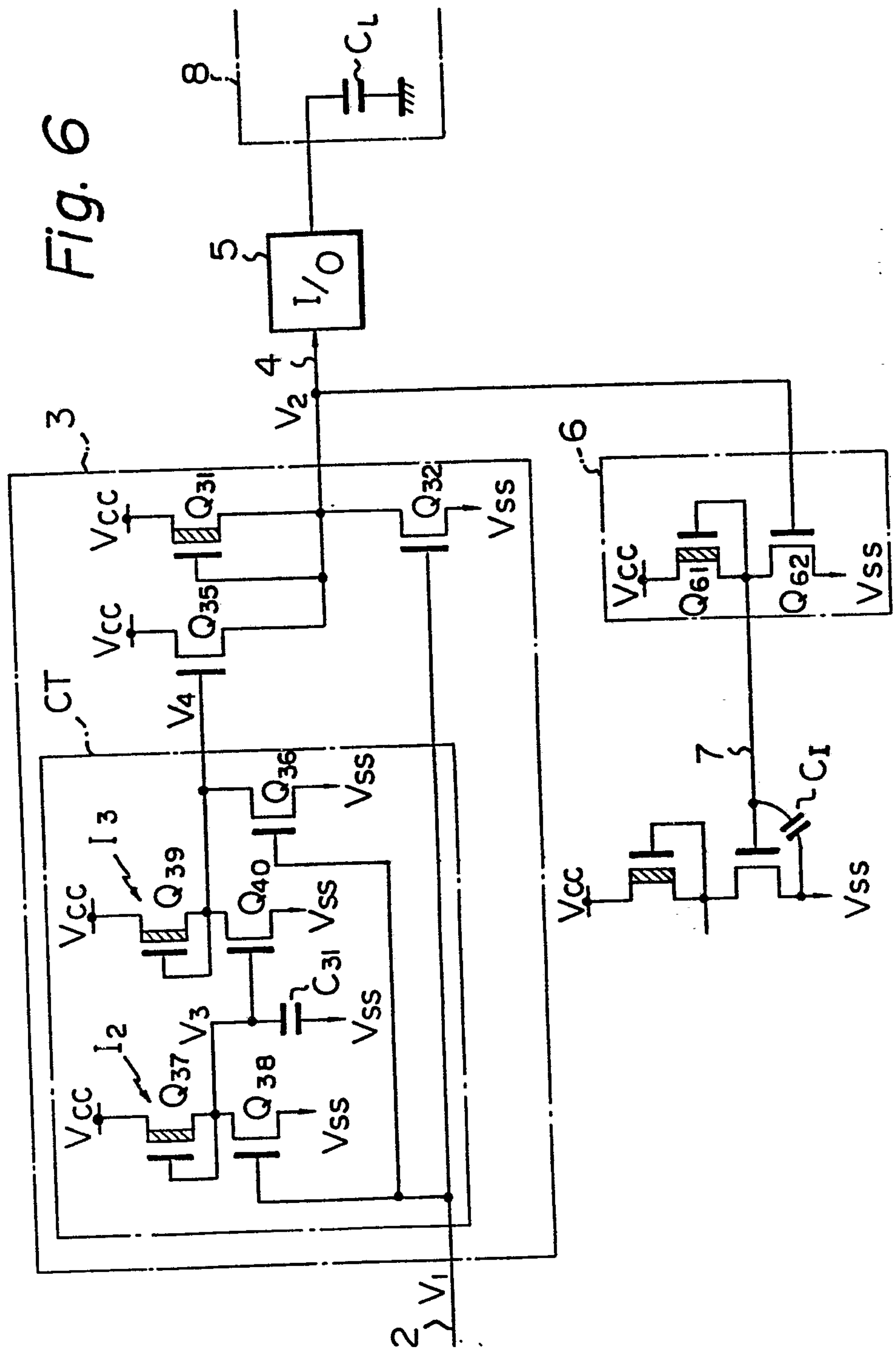
3
CT
Vcc
Q31
Q35
Q32
Vss
V2
4
5
I/O
8
CL
V4
Q36
I3
Q39
Q40
C31
V3
I2
Q37
Q38
V1
2
6
Q61
Q62
7
CI

Fig. 7A

Fig. 7B

Fig. 7C

Fig. 7D

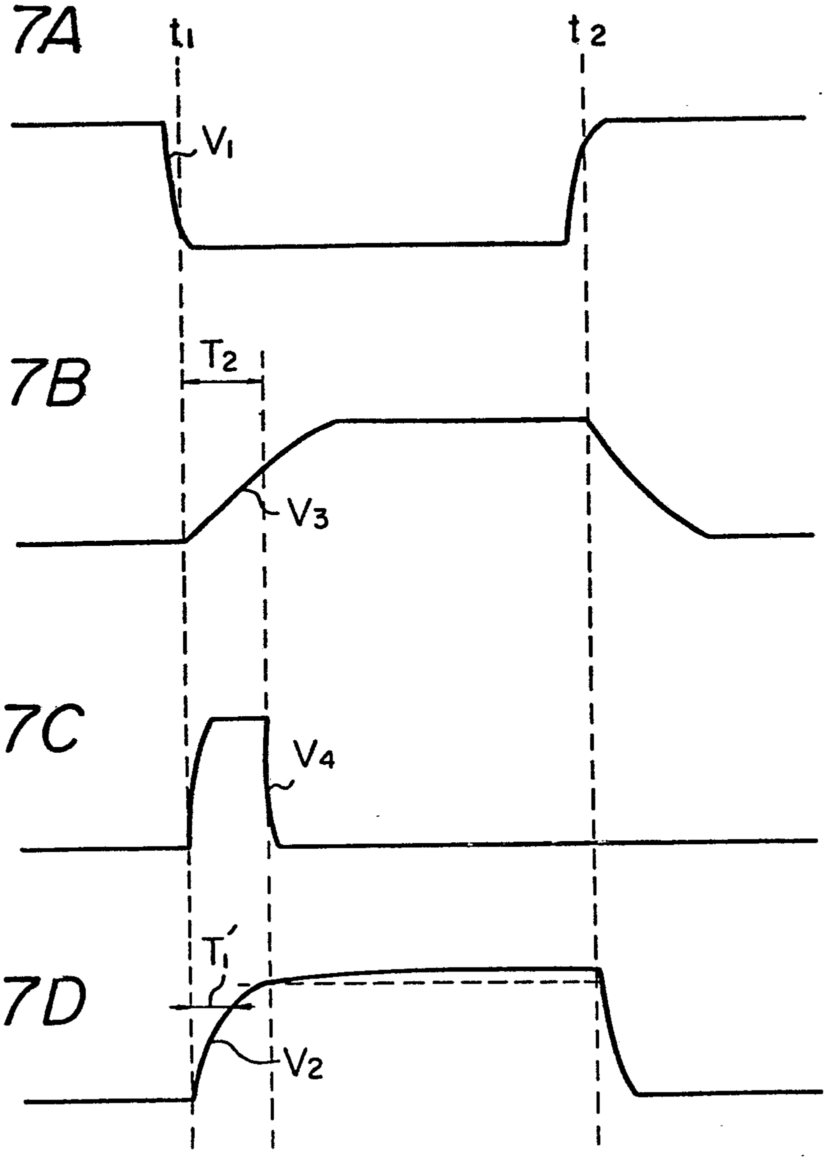

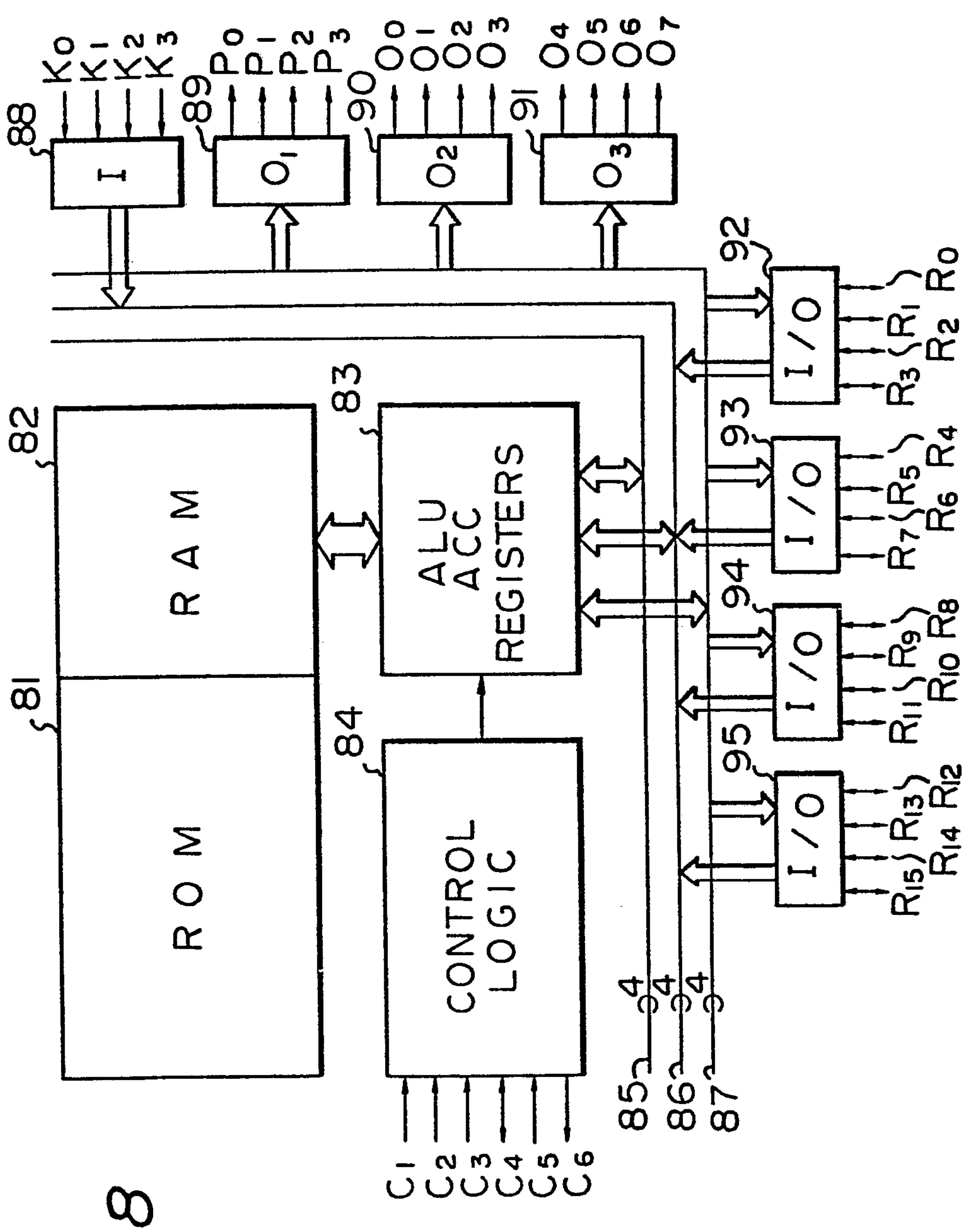


Fig. 8